(19) Europäisches Patentamt / European Patent Office / Office européen des brevets

(11) **EP 2 660 846 A1**

(12) **EUROPEAN PATENT APPLICATION**
published in accordance with Art. 153(4) EPC

(43) Date of publication:
**06.11.2013 Bulletin 2013/45**

(51) Int Cl.:
**H01J 37/317** (2006.01)  **H01J 37/22** (2006.01)
**H01J 37/244** (2006.01)  **H01J 37/28** (2006.01)

(21) Application number: **11853766.1**

(22) Date of filing: **08.12.2011**

(86) International application number:
**PCT/JP2011/078379**

(87) International publication number:
**WO 2012/090670 (05.07.2012 Gazette 2012/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2010 JP 2010290544**

(71) Applicant: **Hitachi High-Technologies Corporation Tokyo 105-8717 (JP)**

(72) Inventors:
• **NANRI Terutaka**
  **Ibaraki 312-8504 (JP)**
• **TOMIMATSU Satoshi**
  **Ibaraki 312-8504 (JP)**
• **AGEMURA Toshihide**
  **Ibaraki 312-8504 (JP)**

(74) Representative: **Beetz & Partner Patentanwälte Steinsdorfstrasse 10 80538 München (DE)**

(54) **CHARGED PARTICLE BEAM DEVICE AND METHOD OF MANUFACTURE OF SAMPLE**

(57)     A precision of removal of a damaged layer (202) of a sample (101) created by machining with an FIB machining device depends on a skill of an operator. During removal machining of the damaged layer (202) generated by an ion beam (105), transmitted electrons which are generated by irradiating an electron beam (111) formed in an electron beam optics system (112) onto a sample (101) are detected by a two-dimensional detector (117), and a moment for finishing the removal machining of the damaged layer (202) is determined based on the amount of blur of a diffraction pattern (208, 301) acquired with the two-dimensional detector (117).

FIG. 4

```
                    ┌─────────┐
                    │  START  │
                    └────┬────┘
                         │
STEP 401      ┌──────────────────────┐
              │   INTRODUCE SAMPLE   │
              └──────────┬───────────┘
                         │
STEP 402  ┌──────────────────────────────────┐
          │ ADJUST MACHINING POSITION OF ION  │
          │              BEAM                 │
          └──────────────┬───────────────────┘
                         │
STEP 403  ┌──────────────────────────────────┐
          │ START REMOVAL MACHINING OF        │
          │         DAMAGED LAYER             │
          └──────────────┬───────────────────┘
                         │
STEP 404  ┌──────────────────────────────────┐◄──┐
          │   ACQUIRE DIFFRACTION PATTERN     │   │
          └──────────────┬───────────────────┘   │
                         │                        │
STEP 405  ┌──────────────────────────────────┐   │
          │ QUANTIZE AMOUNT OF BLUR AND       │   │
          │        DISPLAY ONTO SCREEN        │   │
          └──────────────┬───────────────────┘   │
                         │                        │
STEP 406        ╱PRESENT AMOUNT OF╲        NO     │
               ╱ BLUR OR CHANGE    ╲──────────────┘
               ╲ AMOUNT OF BLUR    ╱
                ╲ ≤ THRESHOLD?    ╱
                    ╲        ╱
                       │ YES
STEP 407  ┌──────────────────────────────────┐
          │ STOP IRRADIATION OF ION BEAM      │
          │          ONTO SAMPLE              │
          └──────────────┬───────────────────┘
                         │
                    ┌─────────┐
                    │   END   │
                    └─────────┘
```

EP 2 660 846 A1

**Description**

TECHNICAL FIELD

The present invention relates to a charged particle beam device for machining a semiconductor device or the like for the purpose of an inspection and a defect analysis, and to a sample manufacturing method using such a device.

BACKGROUND ART

With miniaturization of a circuit pattern constructing a semiconductor device, inspection of an electronic defect and investigation of causes become important. Particularly, in order to investigate causes of generation of defects, importance of such a defect analysis, in which shapes and materials are analyzed while a sample is cut and machined, is increasing. When the miniaturization reaches a level of nanometers, an analysis with a Transmission Electron Microscope (hereinafter, referred to as a "TEM") or a Scanning Transmission Electron Microscope (hereinafter, referred to as a "STEM") is indispensable. In observations with these microscopes, a sample has to be cut and machined into a sample piece of proper dimensions.

It is necessary that a sample piece to be observed with a TEM or a STEM is machined into a thin piece having a thickness of about 100 nanometers through which an electron beam can transmit. Conventionally, a Focused Ion Beam (hereinafter, referred to as "FIB") machining device is used in such a kind of machining. In a FIB machining device, an ion beam which has been finely focused is scanned by an electrostatic deflection and a sample is machined.

However, in the machining with a FIB machining device, an ion penetrates into the inside of the sample. Therefore, there are the following problems.

For example, when the sample has a crystal structure, there is such a problem that the crystal structure is broken by irradiation of the ions to create a so-called damaged layer. The damaged layer becomes an obstacle of an electron beam. Thus, an electron beam image of the original crystal structure which is wished to be observed with a TEM or a STEM cannot be clearly observed with the microscope. Therefore, there has been known conventionally a method whereby after machining with a FIB machining device, an ion beam from a gaseous ion source is irradiated to a damaged layer at a low acceleration and the damaged layer is removed.

When the damaged layer is removed, it is important that not only the damaged layer is removed but also an end point of the machining is detected so as not to excessively machine the sample which should originally be left. A method of removing a damaged layer while visually observing a STEM image has been proposed in Patent Literature 1.

CITATION LIST

PATENT LITERATURE

    Patent Literature 1: JP-A-2007-193977
    Patent Literature 2: JP-A-2009-129221
    Patent Literature 3: JP-A-6-060186

SUMMARY OF INVENTION

TECHNICAL PROBLEM

However, in order to determine whether or not a damaged layer having a thickness of a few nanometers could have been removed merely by visually confirming a change of image quality of a STEM image, an advanced technique is required for an engineer. Further, in the defect analysis which is performed at the startup of production of new semiconductor device products, since new structures and materials are used, it is very difficult to determine whether or not a damaged layer has been removed only by a change of image quality of a STEM image.

Therefore, the present inventors intend to provide a charged particle beam device with which a damaged layer of a sample caused by machining with an FIB machining device can be removed minimally and without a shortage, and a sample manufacturing method using such a device.

SOLUTION TO PROBLEM

In the invention, therefore, during removal machining of a damaged layer generated by an ion beam, transmitted electrons which are generated by irradiating an electron beam formed in an electron beam optics system onto a sample are detected by a two-dimensional detector, and a moment for finishing the removal machining of the damaged layer is determined based on the amount of blur of a diffraction pattern acquired with the two-dimensional detector. In this description, the amount of blur is a value which is calculated by function-converting a luminance value appearing in the diffraction pattern and is one with which a thickness of the damaged layer is reflected by the calculated value. So long as such a characteristic is fulfilled, a function to give the amount of blur would be non-specific.

ADVANTAGEOUS EFFECTS OF INVENTION

According to the present invention, an end-point moment of removal machining of a damaged layer can be automatically detected. Thus, a failure of the removal machining can be prevented without depending on presence or absence of information regarding material and/or structure of the sample and a skilled technique of an operator. Other problems, configurations, and advantages will be clarified by the following description of embodiments.

BRIEF DESCRIPTION OF DRAWINGS

FIG. 1 is a diagram showing an example of a configuration of a charged particle beam device;
FIG. 2 is a diagram for explaining an example of a cross sectional structure of a thin sample;
FIG. 3 is a diagram showing a diffraction pattern;
FIG. 4 is a flowchart for explaining a removing procedure of a damaged layer;
FIG. 5 is a diagram for explaining an example of areas which are used in a calculation of the amount of blur;
FIG. 6 is a diagram showing an example of halo patterns;
FIG. 7A is a diagram showing an example of an interface screen which is displayed onto a display apparatus;
FIG. 7B is a diagram showing an example of an interface screen which is  displayed onto the display apparatus;
FIG. 8A is a diagram showing time-series changes of the amount of blur and a blur change amount;
FIG. 8B is a diagram showing time-series changes of the amount of blur and a blur change amount; and
FIG. 9 is a flowchart for explaining another removing procedure of a damaged layer.

DESCRIPTION OF EMBODIMENTS

Embodiments of the present invention will be described hereinafter based on the drawings. The embodiments of the present invention are incidentally not limited to an example of modes described below, but various modifications are possible within a scope of its technical concept.

<Example of Modes>

(1) Device Configuration

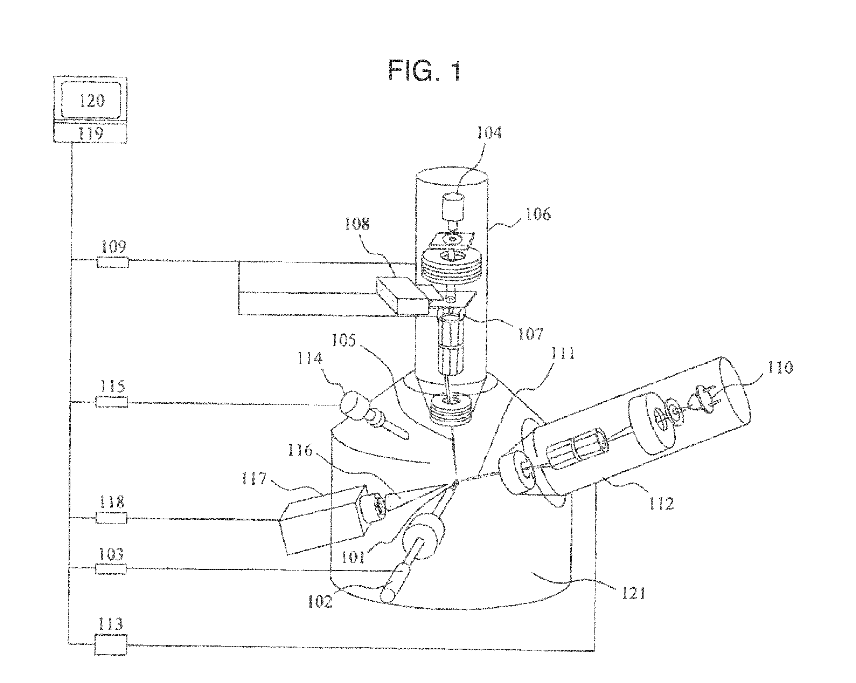

FIG. 1 shows a configuration diagram of a charged particle beam device. The charged particle beam device has: a movable sample stage 102 on which a sample 101 is mounted; a sample position control unit 103; an ion beam optics system apparatus 106; an ion beam optics system control unit 109; an electron beam optics system apparatus 112; an electron beam optics system control unit 113; a secondary electron detector 114; a secondary electron detector control unit 115; a two-dimensional detector 117; a two-dimensional detector control unit 118; a central processing unit 119; a display apparatus 120; and a vacuum container 121.
Here, the sample position control unit 103 is a control unit of the sample stage 102 and controls a position and an attitude of the sample 101.
The ion beam optics system apparatus 106 is an apparatus for irradiating an ion beam 105 on the sample 101 to machine and is constructed with: an ion source 104; a blanker 107; a closing mechanism 108; a deflecting coil; an objective lens; and the like. In the case of this embodiment, the ion source 104 generates ions of low accelerations (low energies) for removing a damaged layer. Speeds of the ions can be also varied, however, via control of an extraction voltage and an accelerating voltage. The ion source 104 may also be one which can  selectively generate not only the ions of low accelerations but also ions of high accelerations (high energies) for sample machining. The blanker 107 is used for blanking of the ion beam 105. The closing mechanism 108 controls arrival of the ion beam 105 onto the sample 101 via control of a shielding mechanism such as a shielding plate. For example, when the shielding plate shields a beam path of the ion beam 105, the machining of the sample 101 by the ion beam 105 is stopped. The ion beam optics system control unit 109 is an apparatus for controlling the ion beam optics system apparatus 106.

The electron beam optics system apparatus 112 is an apparatus for irradiating an electron beam 111 on the sample 101 to observe a microscope image and is constructed with: an electron source 110; a deflecting coil; an objective lens; and the like. The electron beam optics system control unit 113 is an apparatus for controlling the electron beam optics system apparatus 112.

The secondary electron detector 114 is an apparatus for detecting secondary electrons, reflected electrons, or the like, which are generated at the sample 101 by irradiation of the electron beam 111. The secondary electron detector control unit 115 is an apparatus for controlling the secondary electron detector 114.

The two-dimensional detector 117 is an apparatus for detecting transmitted electrons 116 which pass through the sample 101 when the electron beam 111 is irradiated, and has plane resolution enough to recognize diffraction spot images and/or halo patterns which are superimposed thereto. The two-dimensional detector control unit 118 is an apparatus for controlling the two-dimensional detector 117.

The central processing unit 119 is an apparatus for controlling the sample position control unit 103, the ion beam optics system control unit 109, the electron beam optics system control unit 113, the secondary electron detector control unit 115, and the two-dimensional detector control unit 118. The central processing unit 119 operates control data of these control units and outputs to the corresponding apparatus. As for a central processing unit 119, for example, a personal computer, a work station, or the like is generally used. The display apparatus 120 has a display. The display apparatus 120 is used to display an interface screen.

The vacuum container 121 is a closed container for accommodating the sample 101 in a vacuum atmosphere. The sample stage 102, the ion beam optics system apparatus 106, the electron beam optics system apparatus 112, the secondary electron detector 114, and the two-dimensional detector 117 are also arranged in the vacuum container 121.

The charged particle beam device shown in FIG. 1 operates as follows although the details will be described later. First, during removal of a damaged layer of the sample 101 by the ion beam 105 (namely, during machining with the ion beam 105 formed by the ion beam optics system apparatus 106), the transmitted electrons 116 which pass through the sample 101 by irradiation of the electron beam 111 are detected with the two-dimensional detector 117. Subsequently, the central processing unit 119 determines an end-point moment for the damaged layer removal machining with the ion beam 105 based on the amount of blur of an area of interest in an electron diffraction image (diffraction pattern) acquired in the two-dimensional detector 117. When the central processing unit 119 determines that the moment suitable to finish the removal machining of the damaged layer has come, it drive-controls the shielding plate of the closing mechanism 108, thereby shielding the ion beam 105 so that the ion beam 105 does not reach the sample 101.

(2) Removal Machining of Damage Layer and Detection of Machining End-Point Moment

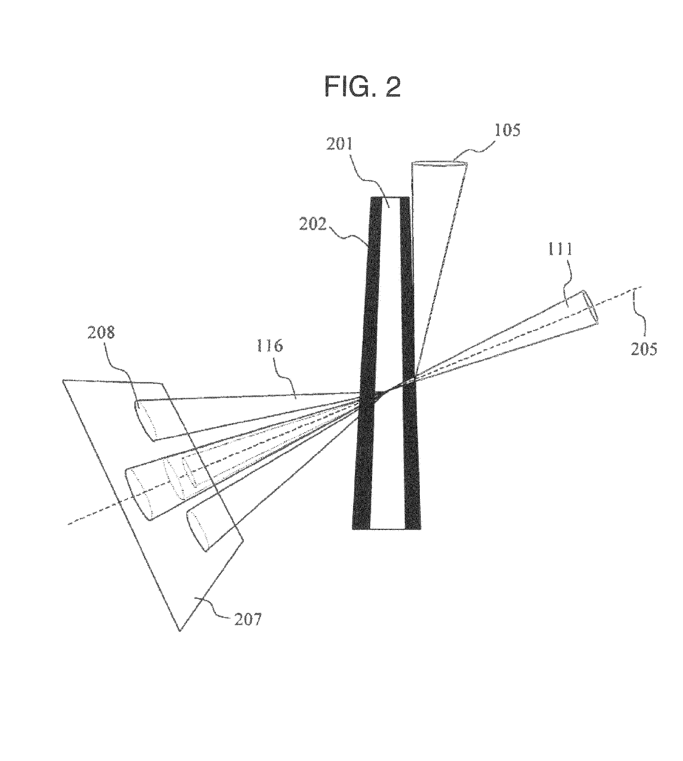

It is shown in FIG. 2 how irradiation of the ion beam for the removal machining of a damaged layer 202 by the ion beam 105 and irradiation of the electron beam for automatic detection of the end-point moment of machining are executed. FIG. 2 illustrates the sample after it was already machined into a shape serving as an observation/analysis target by high acceleration FIB machining.

As illustrated in FIG. 2, the damaged layer 202 is formed in a skin portion of a target sample 201. When the damaged layer 202 exists, an image in which not only diffraction patterns 208 of the target sample 201 but also halo patterns by the damaged layer 202 are superimposed is observed on a photosensitive plane 207 of the two-dimensional detector 117.

Therefore, a state of the target sample 201 cannot be clearly observed, and as result an accurate analysis cannot be performed. Therefore, the removal machining of the damaged layer 202 with the ion beam 105 is performed.

It is desirable to use a beam of gaseous ions of a low accelerating voltage for the removal machining of the damaged layer 202. For example, it is desirable to use a low energy ion beam of 1 kV or less. It has been known that low energy ion beams of 1 kV or less have shallow penetration depths into samples and creation of a new damaged layer during removal machining of the damaged layer can be mitigated.

Moreover, the gaseous ion beam has an advantage that, even when it is emitted at a low accelerating voltage, it is difficult to pollute the sample 101. There is, for example, an argon beam or a xenon beam as such a kind of the gaseous ion beam. In addition, a liquid metal ion source may also be used as an ion source for removal machining of the damaged layer. This is because a liquid metal ion beam is possible to suppress a thickness of the created damaged layer to about a few nanometers.

To the contrary to these, a liquid metal ion beam of a low accelerating voltage raises a problem that a deposition amount becomes larger than a machining amount and the liquid metal is adhered onto the sample. Therefore, it is generally undesirable to apply the liquid metal ion beam to the removal machining of the damaged layer.

In consideration of these, if a gaseous ion source or a liquid metal ion source is used as an ion source, from high acceleration FIB machining to low acceleration FIB machining can be realized by one device. If high acceleration FIB machining and low acceleration FIB machining can be performed with one device, a manufacturing time of the sample can be shortened. In addition, the ion beam optics system apparatus 106 can be made of two apparatuses of different ion sources. For example, it is also possible to construct a charged particle beam device in which a liquid metal ion source is adopted as an ion source of one of the ion beam optics system apparatuses and a gaseous ion source is adopted as an ion source of the other ion beam optics system apparatus. In the case where the device has two kinds of ion beam optics systems of different ion sources, merits of the two ion sources can be obtained and a sample of high quality can be manufactured in a short time.

Now, as mentioned above, in the removal machining of the damaged layer, timing of stopping machining is very important. In the case of the present invention, the amount of blur of an electron diffraction image (diffraction pattern) focused on the photosensitive plane 207 of the two-dimensional detector 117 is determined by the central processing unit 119 and the moment for stopping the machining by the ion beam is controlled based on a result of the determination.

The electron diffraction image (diffraction pattern) is obtained by a part or most of the electron beam 111, which is irradiated on the sample 101 and has an optical axis 205, being transmitted to the back surface of the sample while being scattered elastically or inelastically in the sample, and being focused onto the photosensitive plane 207 of the two-dimensional detector 117. In the case of this example of the modes, an image sensor, such as CCD camera or CMOS camera, for example, which can determine a detecting position in two dimensions and can detect an intensity at each detecting position, is used as a two-dimensional detector 117.

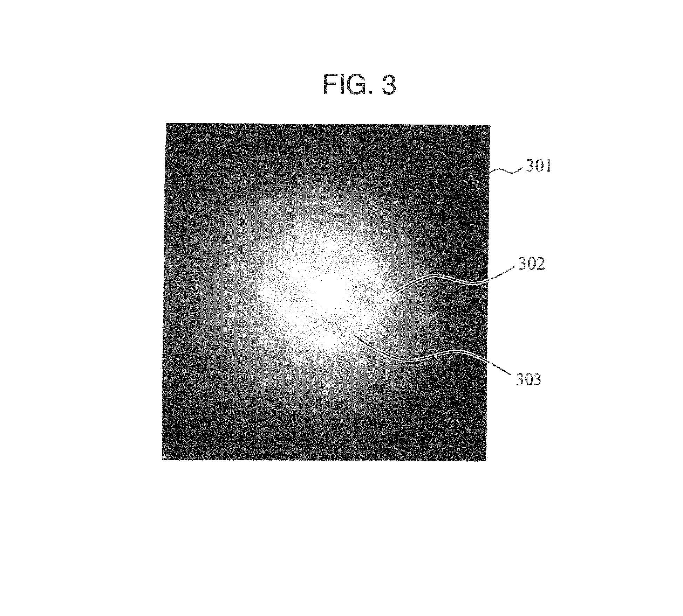

FIG. 3 shows an example of a diffraction pattern 301 which is detected with the two-dimensional detector 117. In the diffraction pattern 301, diffraction spots 302 which are caused by the target sample 201 (crystal layer) and halo patterns 303 which are caused by the damaged layer 202 appear.

At this time, if the thickness of the sample is shorter than a mean free path of the irradiated electron beam, the electrons which are transmitted/scattered by the target sample 201 can be regarded as being interacted with only either the crystal layer or the damaged layer. In this case, the amount of blur ofthe diffraction patterns 301 including the halo patterns 303 can be quantized and the thickness of the present damaged layer can be quantitatively obtained. The central processing unit 119 of the present embodiment compares the quantized blur amount with an arbitrary threshold value and grasps a degree of removal ofthe damaged layer from a result of comparison, thereby determining the stopping moment of machining.

Incidentally, decrease in the amount of blur and increase in sharpness of the diffraction pattern have the same meanings. Quantization of the halo patterns and quantization ofthe amount of blur ofthe diffraction patterns also have the same meanings. Also, the diffraction pattern is obtained not only during machining, but machining and acquisition of the diffraction pattern may be alternately performed.

(3) Removal Process of Damaged Layer (Part 1)

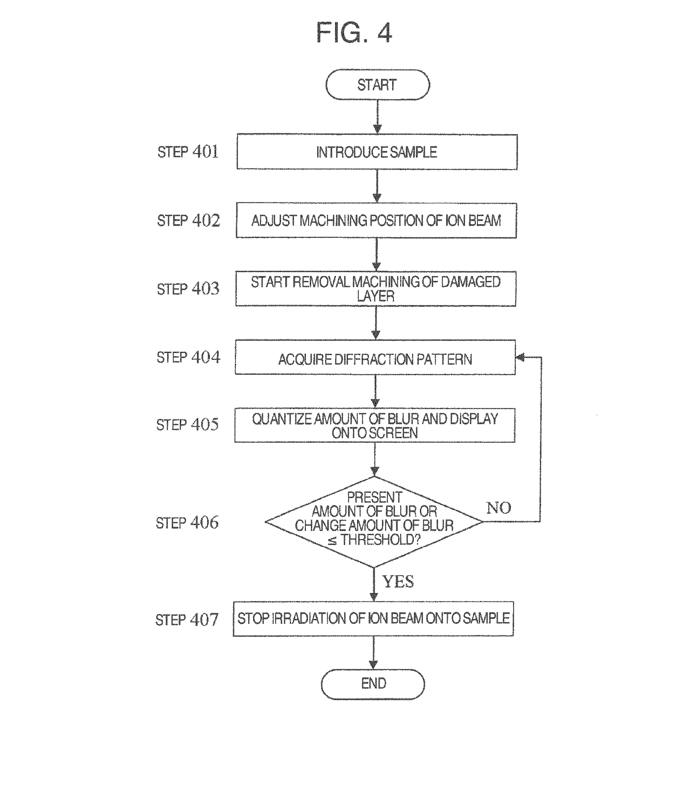

Next, an outline of an operation accompanying the removal of the damaged layer will be described. FIG. 4 shows a procedure of processing operation which is executed with the removal of the damaged layer.

First, an operator mounts the sample 101 having the damaged layer onto the sample stage 102 and introduces into the vacuum container 121 (Step 401). This operation is manually executed. Incidentally, in the case of the charged particle beam device which can selectively execute the machining of the sample and the removal of the damaged layer by switching of the ion beam energy, the removal of the damaged layer is continuously executed subsequent to the FIB machining. In the case where the removal operation of the damaged layer is executed while the sample 101 remains being introduced in the vacuum container 121 as mentioned above, the introduction step 401 of the sample is not necessary.

Next, the operator adjusts the position and the orientation of the sample 101 so that a low acceleration ion beam is properly irradiated with respect to the machining position (Step 402). At this time, the operator adjusts the orientation of the sample 101 while visually checking the interface screen displayed on the display apparatus 120. Specifically, an instruction is given to the central processing unit 119 through an input apparatus (not shown) and adjusts the position and the orientation of the sample stage 102. After this adjustment, the irradiating position of the ion beam is positioned to the machining position of the sample 101. The machining position is adjusted based on machining scars of the ion beam, a secondary electron image by the electron beam, and the positional relation between the sample stage and the sample.

Subsequently, the operator instructs start of the removal machining of the damaged layer while visually observing the screen displayed on the display apparatus 120 (Step 403). An instruction to start the machining is also given to the central processing unit 119 through an input apparatus (not shown). When the removal machining of the damaged layer is started, the central processing unit 119 controls the closing mechanism 108, thereby causing the shielding plate to escape from the path of the ion beam. As a result, the low acceleration ion beam reaches the sample 101 and the removal of the damaged layer is started.

The central processing unit 119 acquires the diffraction pattern (FIG. 3) from the two-dimensional detector 117 simultaneously with the start of the removal machining of the damaged layer (step 404).

Next, the central processing unit 119 quantizes the amount of blur of the acquired diffraction pattern. One of the following methods is used for quantization of the amount of blur. Incidentally, the quantizing process of the amount of blur by the central processing unit 119 may be executed to the whole image area of the diffraction pattern or executed with respect to only a partial area.

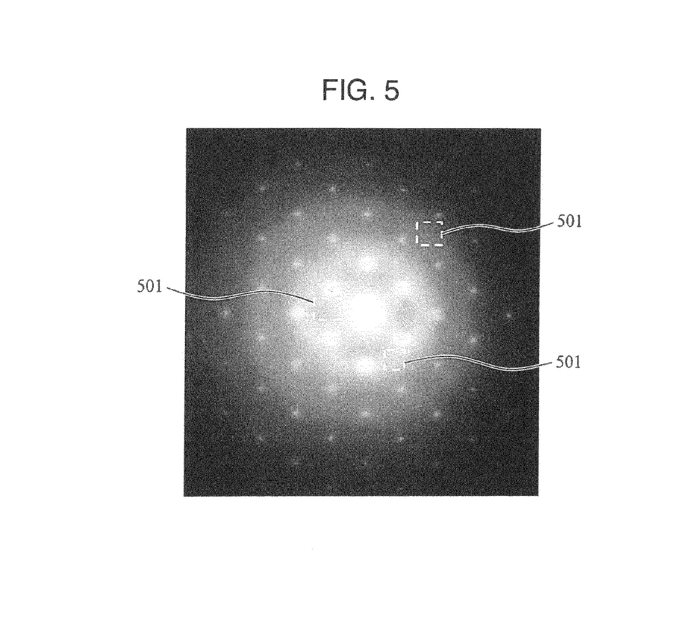

FIG. 5 shows an area selection image in the case where a plurality of partial areas 501 (three positions in the figure) are selected from the diffraction pattern and the amount of blurs are quantized with respect only to the partial areas 501. Here, the area to which the quantizing process is applied may be manually selected by the operator through a GUI (Graphical User Interface) or automatically selected by the central processing unit 119 in accordance with a prescribed rule. Also, partial areas 501 may not be necessarily plural but only one may be selected.

Incidentally, if the whole area of the diffraction pattern is rendered to be a processing target, a structure of a program which is executed by the central processing unit 119 can be simplified compared with the case where only the partial areas are rendered to be processing targets.

When only partial areas 501 are made to be processing targets, on the other hand, by setting the partial areas 501 to areas other than the diffraction spots, only the halo patterns attributed to the damaged layer can be selected as a processing target. In this case, since information of the diffraction spots is not included in the quantization data, the reliability of the quantized blur amount can be enhanced. All the partial areas 501 in FIG. 5 are set so as to avoid the diffraction spots.

Further, when the positions of the diffraction spots can be automatically specified from the relations among respective inclination angles of a crystal orientation of the sample, the electron beam, and the sample stage, and from the acquired diffraction pattern, the partial areas 501 can be automatically selected through signal processing by the central processing unit 119. Incidentally, in order to automatically select only in appearing areas of the halo patterns from the diffraction pattern in which the diffraction spots and the halo patterns are mixed together, it is necessary that the central processing unit 119 has or can obtain, not only information regarding the positions and spot diameters of the diffraction spots, but also information regarding the luminance of the halo patterns which spread in a form of concentric circles.

Incidentally, the halo patterns have such characteristics in general that the luminance on the inner circumference appears higher than that of the peripheral portion. Therefore, in order to judge a remaining amount of the damaged layer through the amount of blur of the halo patterns, it is desirable that the partial areas 501 are set inside of the halo patterns as much as possible to observe a decrease in the amount of blur. It must, however, be added that the halo pattern which shows up at the center of the diffraction pattern overlaps the diffraction spot which appears at the same position. Therefore, at the time of automatic setting of the partial areas 501, it is desirable that the halo pattern located at the center of the diffraction pattern is avoided and the areas which do not overlap the diffraction spots are selected as partial areas 501.

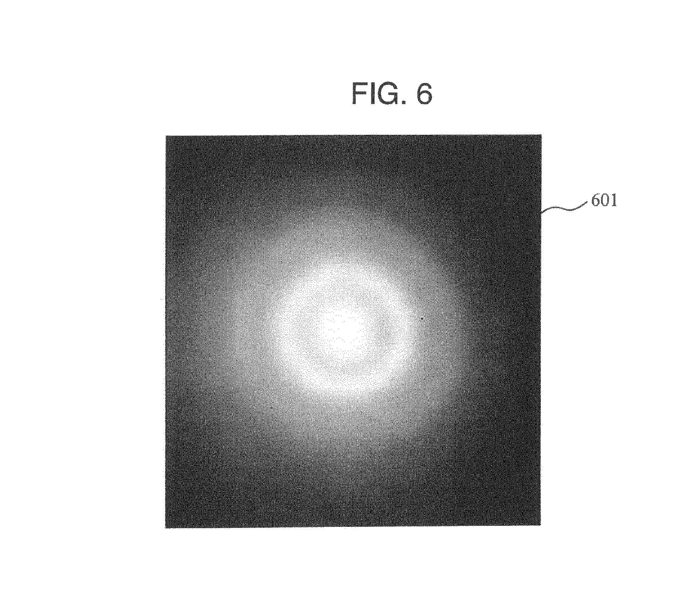

Further, it is also possible that only the diffraction spots are excluded from the diffraction pattern by a filtering process, and the diffraction pattern after the filtering process (namely, only the halo patterns) is set to a target for the quantizing process of the amount of blur to be executed. Here, as a method of extracting only halo patterns 601 such as shown in FIG. 6, there is a method of excluding only the diffraction spots based on a relation between the luminance and changes in diameters of the diffraction spots which show up on concentric circles. Besides, the halo patterns have characteristics such that changes in luminance at the circumferential positions of each radius are constant. Therefore, a portion having a change can be determined as a diffraction spot. Accordingly, a method may be used whereby an area having a luminance change on the same radius is regarded as a diffraction spot and is excluded from the diffraction pattern.

Return to the description of FIG. 4. Subsequently, the central processing unit 119 calculates (quantizes) the amount of blur as a numerical value from the acquired diffraction pattern and displays the calculated amount of blur onto the display apparatus 120 (Step 405). Incidentally, a function which is used for the calculation of the amount of blur differs depending on whether the diffraction pattern is also included in the processing area or only the halo patterns are there, or whether it is a partial area or the whole area. For example, in the case of rendering partial areas 501 as processing targets, a value obtained by processing an average luminance with functions may be given as the amount of blur.

In this example of the modes, the amount of blur is defined as a sum of respective spatial frequency components. This definition is derived by the following explanation. First, a Fourier transform F(μ, v) for an image f(x, y) is obtained by the following equation.

[MATH. 1]

$$F(\mu, v) = \iint f(x, y) \exp(-j2\pi(\mu x + vy)) \, dx \, dy$$

Here, x and y indicate parameters representing a position in the image and μ and ν denote spatial frequencies.

At this time, a power spectrum P(μ, v) of F(μ, v) is defined by the following equation.
$$[\text{MATH. 2}]$$

$$P(\mu, v) = |F(\mu, v)|^2$$

A value of the power spectrum P(μ, v) indicates an intensity of the spatial frequency (μ, v). When the power spectrum P(μ, v) is expressed in a polar coordinate format, it becomes P(r, θ). Then, P(r) is defined as follows.
$$[\text{MATH. 3}]$$

$$P(r) = \int_0^{2\pi} P(r, \theta)\, d\theta$$

Here, letting an original image be f1(x), a blurred image be f2(x) (for simplicity of explanation, they are now considered as one-dimensional images), and their Fourier transforms are F1(μ) and F2(μ), respectively, the following equation holds between F1(μ) and F2(μ).
$$[\text{MATH. 4}]$$

$$F2(\mu) = F1(\mu)\exp(-\frac{\delta^2 \mu^2}{2})$$

Here, δ denotes a constant representing the amount of blur. From this equation, it would be understood that all of the frequency components other than the DC component decrease when the image is blurred.
Thus, in the present embodiment, the amount of blur E is defined as a sum of respective spatial frequency components given by the following equation.
$$[\text{MATH. 5}]$$

$$E = \sum_r \log P(r)$$

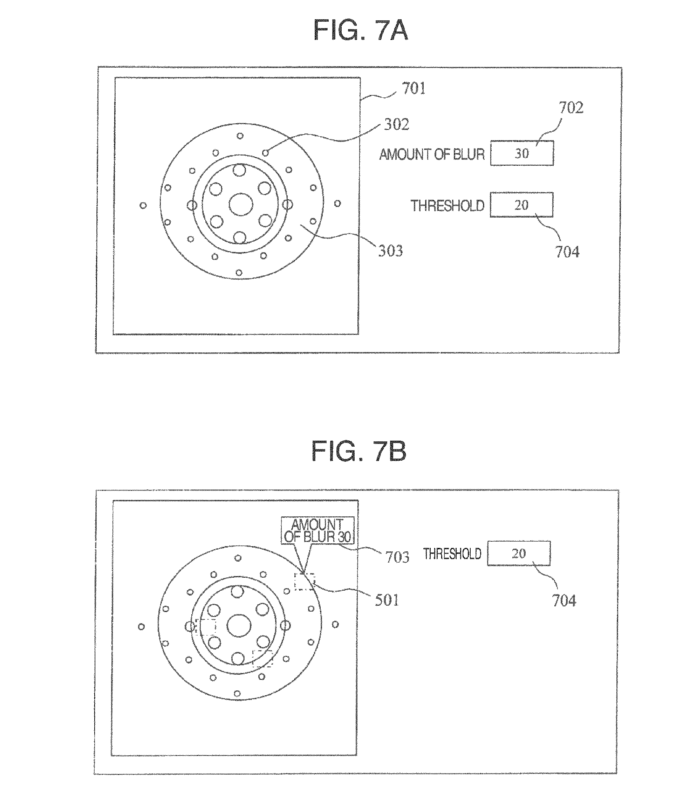

FIGs. 7A and 7B show examples of GUI screens used to display the amount of blur. The GUI screens shown in FIGs. 7A and 7B illustrate the examples in which the diffraction pattern is displayed as a schematic diagram in a display column 701. Of course, display of the display column 701 is not limited to the schematic diagram but may be a diffraction pattern image (FIG. 3) itself acquired by the two-dimensional detector 117. Also, a diffraction pattern in which image processing of, for example, one of luminance adjustment, display of numerical values, and color display, or a combination of a plurality of them is executed to the acquired diffraction pattern may be displayed. By displaying the diffraction pattern subjected to the image processing, a state of the sample during the removal machining of the damaged layer can be easily recognized.
Furthermore, the screen of FIG. 7A shows an example in which a display column 702 of the quantized amount of blur and a display column 704 of a threshold value are arranged separately from the display column 701 of the diffraction pattern; however, as shown in the screen of FIG. 7B, a display column 703 of the amount of blur may be displayed in a pop-up format to the partial area 501. Now, the display column 703 is associated with three partial areas 501. In the case of the screen of FIG. 7B, the amount of blur can be recognized without moving the eyes away from the diffraction pattern 701. In the case of the examples of the screens of FIGs. 7A and 7B, the amount of blur is "30" and the threshold value is "20" for both.
Besides, the amount of blur which is calculated with the elapse of the machining processing may be displayed as a time-series graph onto the GUI screen.

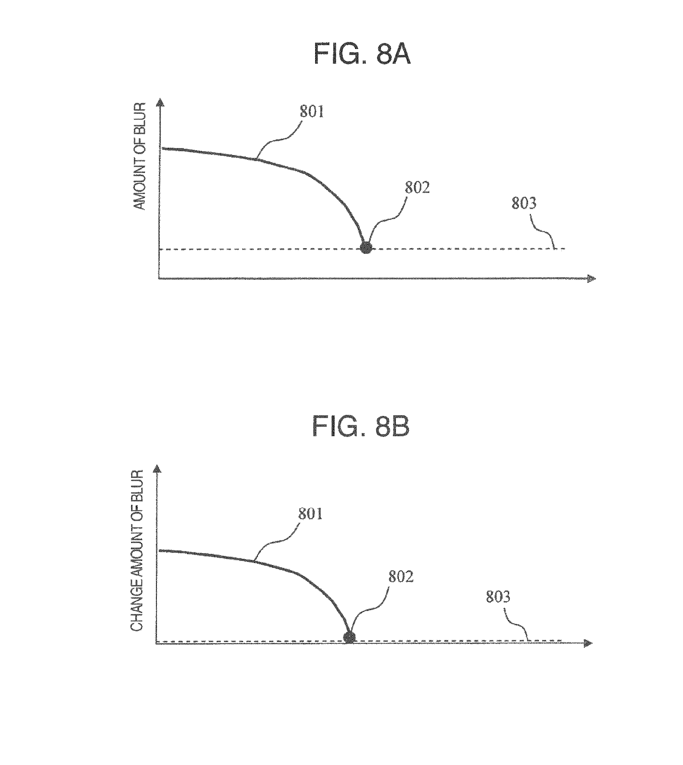

FIGs. 8A and 8B show examples of graphs of this kind. In the screens of FIGs. 8A and 8B, an abscissa indicates time and an ordinate denotes a magnitude of the amount of blur. In the screen of FIG. 8A, a curve 801 shown with a bold line indicates the amount of blur which was calculated in the past, and a black circle 802 indicates a present value of the amount of blur. From the curve 801 and the black circle 802, a state of attenuation of the amount of blur can be easily known. Incidentally, the screen of FIG. 8B is a graph in which an ordinate indicates the change amount of the amount of blur.

In FIGs. 8A and 8B, a threshold value is shown with a broken line 803. The threshold value 803 is a value which gives the end point of time of the machining with the low acceleration ion beam. For example, in FIG. 8A, the threshold value can be set to a value such as "0" or the like which can be easily understood. In each of FIGs. 7A, 7B, 8A, and 8B, the calculated value is handled as the amount of blur; however, in the case where a relation between the amount of blur and the thickness of the damaged layer is known in advance (for example, in the case where the correspondence is stored in a ,memory area in the central processing unit 119), the calculated amount of blur may be converted into "the thickness of the damaged layer", "the film thickness", and other information to handle. By handling the film thickness itself, understanding by the operator becomes easy.

Now, return to explanation of FIG. 4. Subsequently, the central processing unit 119 compares the threshold value 803 set in advance with the present amount of blur or the change amount of blur (Step 406). In the case of this example of the modes, it is determined whether or not the present amount of blur or the change amount of blur is equal to or less than the threshold value. When a negative result is obtained, the central processing unit 119 continues the machining with the ion beam. Therefore, the central processing unit 119 returns to Step 404 and acquires a new diffraction pattern. When a positive result is obtained, on the other hand, the central processing unit 119 advances to Step 407 and controls so as to stop the irradiation of the ion beam.

By the way, the threshold value 803 can be set and changed in the GUI screen shown in FIG. 7A, 7B, 8A, or 8B. For example, in the GUI screen shown in FIG. 7A, the operator directly inputs a numerical value into the display column 704, so that the threshold value can be set. Also, for example, in the GUI screen shown in FIG. 8A, it can be set by drawing the broken line 803 showing the threshold value onto the graph. Of course, the type of line which is used for designation of the threshold value is not limited to the broken line. Furthermore, it is assumed that the GUI screen of FIG. 7A or 7B and the GUI screen of FIG. 8A or 8B are mutually interlocked so that when the threshold value is set in one of the GUI screens, the contents of setting are also reflected to the other GUI screen.

As a specific decision method of the threshold value, there exist a method of setting it from experimental data upon machining of similar samples before, a method of setting it as confirming the display column 701 (FIGs. 7A and 7B) of the diffraction pattern or the change in the amount of blur (FIG. 8A), and the like. Further, in the case where the calculation area of the amount of blur is individually set as a partial area 501, the threshold value is determined in accordance with a distance from the center to such an area. This is because a start value of the amount of blur is high at a position near the center and becomes small in the peripheral portion.

Also, in the case of this example of the modes, the threshold value may be given as an absolute value or may be expressed in a relative magnitude with setting the amount of blur at a point of time when the removal machining of the damaged layer by the ion beam is started to be 100.

Incidentally, although the above description has been made on the assumption that the GUI screens (FIGs. 7A, 7B, 8A, and 8B) are displayed to the display apparatus 120 in parallel with the determination of the end of the removal machining of the damaged layer by the central processing unit 119, it is also possible to construct in such a manner that these GUI screens are not displayed to the display apparatus 120.

Return to the explanation of FIG. 4. When a process result is obtained in Step 406, the central processing unit 119 determines that it reaches an end point of the removal machining of the damaged layer, and controls so as to stop the irradiation of the ion beam to the sample (Step 407). Specifically, the central processing unit 119 drive-controls the shielding plate via the closing mechanism 108 and shields the path of the ion beam.

Incidentally, as a method of stopping the irradiation of the ion beam to the sample, the case of controlling the closing mechanism 108 of a GUN valve has been described in the above explanation; however, other than this, a method can also be adopted such as a method whereby the ion beam is deflected via control of the blanker 107 so that the ion beam does not reach the sample, a method whereby the accelerating voltage of the ion source 104 is dropped, a method whereby the sample position control unit 103 is driven to move the sample 101 out of an irradiation range of the ion beam, or the like. Besides, instead of using only one of these control methods, a plurality of control methods may be combined and used.

As described above, a series of machining processings finishes by execution of Step 407. Of course, after the execution of Step 407, a GUI screen for allowing the operator to confirm whether the threshold value is changed and the removal machining of the damaged layer is repeated again or it is finished as is may be displayed on the display apparatus 120. In the former case, it returns back to the acquisition process of the diffraction pattern of Step 404; in the latter case, it finishes.

(4) Removal Process of Damaged Layer (Part 2)

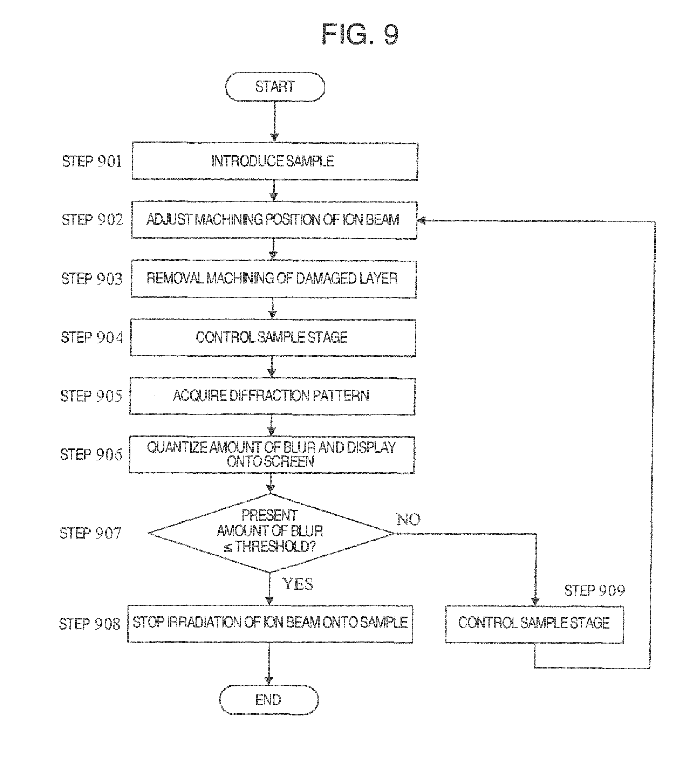

Next, another embodiment of the removing process of the damaged layer will be described. In the foregoing processing procedure, a case where after the machining position of the ion beam is adjusted in Step 402, the machining position of the sample by the ion beam is not changed is presumed. However, like a processing procedure shown in FIG. 9, the machining position may be adjusted as temporarily interrupting the machining processing during the removal machining of the damaged layer. Also, a step of controlling the sample stage 102 to a prescribed position and a prescribed orientation (for example, a step of controlling in such a manner that a cross section of the sample and the optical axis 205 of the electron beam are perpendicular to each other) may be added after the interruption of the removal machining of the damaged layer. By adding such a step, a diffraction pattern at a crystal orientation to be wished to acquire can be determined just before the removal machining of the damaged layer.

Details of the processing procedure shown in FIG. 9 will be described hereinafter. Also in the case of the processing procedure shown in FIG. 9, the introduction of the sample and the adjustment of the machining position by the operator are executed (Steps 901, 902).

Subsequently, the operator sets conditions for interrupting machining (for example, a processing time, the number of scans, and the like) via a GUI screen (not shown) and instructs the start of the removal machining of the damaged layer (Step 903).

In the case of FIG. 9, the removal machining of the damaged layer by the ion beam is interrupted at a moment when the machining interrupting conditions set in advance are satisfied. Namely, by one of the foregoing methods, the central processing unit 119 controls so that it comes to a state where the ion beam does not reach the sample. After the interruption of the machining, the central processing unit 119 drive-controls the sample stage 102 in such a manner that the cross section of the sample and the optical axis 205 of the electron beam are perpendicular to each other (Step 904).

Once the control of the sample stage completes, after that, in a manner similar to Steps 404 to 407 in FIG. 4, acquisition of a diffraction pattern (Step 905), quantization of the amount of blur and display onto a screen (Step 906), comparison between the amount of blur or the change amount of blur at present and the threshold value (Step 907), and a stop of the irradiation of the ion beam to the sample (Step 908) are executed.

A difference from the processing procedure of FIG. 4 is in an aspect that when a negative result is obtained in Step 907 (when it does not fall below the threshold value), the central processing unit 119 executes Step 909 of restoring the amount in which the sample stage was controlled in Step 904 before returning to Step 902, Also, it is in an aspect that in the case of FIG. 9 repetitive steps are Steps 902 to 907 and Step 909.

(Conclusions)

As described above, the charged particle beam device according to the present embodiment adopts the method whereby the film thickness of the damaged layer during the removal machining of the damaged layer with a low acceleration ion beam is quantitatively observed based on the amount of blur which is calculated from the diffraction pattern (luminance distribution). Then, the charged particle beam device according to the present embodiment automatically detects the moment when the calculated amount or change amount of blur becomes equal to or less than the threshold value set in advance as an end moment of the removal machining of the damaged layer and automatically stops irradiation of the ion beam. Thus, a failure of the removal machining can be prevented without depending on the presence or absence of the information regarding the material and the structure of the sample and/or a skilled technique of an operator.

Also, since the charged particle beam device according to the present embodiment has both of the ion beam optics system apparatus 106 and the electron beam optics system apparatus 112 in the vacuum container 121, there is no need to transfer a sample between the low acceleration FIB device and the TEM or STEM apparatus. Therefore, time and labor which are required for transfer can be reduced as compared with those in conventional devices.

Furthermore, the diffraction pattern which is acquired with the charged particle beam device according to the present embodiment can also be used for matching of the crystal orientation of the sample. Therefore, the present device can also contribute to the improvement of a structure analysis technique.

<Other Embodiments>

In the case of the foregoing example of the modes, a case where the ion beam is an ion beam of a single atom is presumed. However, the ion beam may be a cluster ion beam. The cluster ion beam has such a feature that an ion penetration depth is shallow and the damaged layer is difficult to be created as compared with the ion beam of a single atom. Therefore, it becomes possible to remove the damaged layer without decreasing the machining speed even at a low accelerating voltage.

Also, in the case of the foregoing example of the modes, although it is presumed that the ion beam has basically been converged, it may not necessary be converged. Namely, the removal machining of the damaged layer may be executed using a broad ion beam which is not focused. By adopting the broad ion beam, the ion beam optics system apparatus 106 and the ion beam optics system control unit 109 for controlling the ion beam optics system apparatus 106 can be manufactured in a small size inexpensively.

Incidentally, the present invention is not limited to the foregoing embodiments but various modifications are included. For example, the foregoing embodiments have been described in detail in order to explain the present invention so as to be readily understood and are not necessarily limited to what comprising all of the configurations described above. Furthermore, a part of a certain embodiment can be replaced with a configuration of another embodiment, and, moreover, a configuration of another embodiment can also be added to a configuration of a certain embodiment. Besides, with respect to a part of the configuration of each embodiment, another configuration can also be added, deleted, or replaced.

In addition, as for the respective configurations, functions, processing units, processing means, and the like mentioned above, a part or all of them may be realized as, for example, an integrated circuit and other hardware. Also, the respective configurations, functions, and the like mentioned above may be realized by a processor interpreting and executing programs for realizing respective functions. Namely, they may be realized as software. Information such as programs for realizing the functions, tables, files, and the like can be stored in a storage device such as a memory, a hard disk drive, and a SSD (Solid State Drive), or a storage medium such as an IC card, a SD card, a DVD, or the like.

Besides, the control lines and the information lines are shown as for what are considered to be necessary for explanation and all of the control lines and the information lines needed for products are shown necessarily. In reality, it may be considered that almost all of the constituents are mutually connected.

REFERENCE SIGNS LIST

| | |
|---|---|
| 101 | sample |
| 102 | sample stage |
| 103 | sample position control unit |
| 104 | ion source |
| 105 | ion beam |
| 106 | ion beam optics system apparatus |
| 107 | blanker |
| 108 | closing mechanism |
| 109 | ion beam optics system control unit |
| 110 | electron source |
| 111 | electron beam |
| 112 | electron beam optics system apparatus |
| 113 | electron beam optics system control unit |
| 114 | secondary electron detector |
| 115 | secondary electron detector control unit |
| 116 | transmitted electrons |
| 117 | two-dimensional detector |
| 118 | two-dimensional detector control unit |
| 119 | central processing unit |
| 120 | display apparatus |
| 121 | vacuum container |
| 201 | target sample |
| 202 | damaged layer |
| 205 | optical axis of electron beam |
| 207 | photosensitive plane of two-dimensional detector |
| 208 | diffraction pattern |
| 301 | diffraction pattern |
| 302 | diffraction spot |
| 303 | halo pattern |
| 501 | areas used in calculation of amount of blur (partial areas) |
| 601 | extracted halo pattern |
| 701 | display column of diffraction pattern |
| 702 | display column of amount of blur |
| 703 | display column of amount of blur |

704    display column of threshold value
803    threshold value

**Claims**

1. A charged particle beam device comprising:

   an ion source;
   an ion beam optics system apparatus for irradiating an ion beam;
   a first control unit for controlling the irradiation of the ion beam;
   an electron source;
   an electron beam optics system apparatus for irradiating an electron beam;
   a second control unit for controlling the irradiation of the electron beam;
   a sample holding mechanism for holding a sample;
   a vacuum container;
   a two-dimensional detector for acquiring a diffraction pattern which is created by electrons passing through the sample out of the electron beam; and
   a third control unit for calculating an amount of blur of the diffraction pattern at a time of removal machining of a damaged layer of the sample with the ion beam and for controlling a moment for stopping irradiation of the ion beam to the sample based on the amount of blur.

2. The charged particle beam device according to claim 1, wherein the amount of blur is a value which is calculated by function-converting a luminance value appearing in a diffraction pattern.

3. The charged particle beam device according to claim 2, wherein the ion beam is generated in a liquid metal ion source.

4. The charged particle beam device according to claim 2, wherein the ion beam is generated in a gaseous ion source.

5. The charged particle beam device according to claim 2, wherein the third control unit displays the diffraction pattern to a display apparatus during removal machining of a damaged layer.

6. The charged particle beam device according to claim 2, wherein the third control unit detects a moment when the amount of blur becomes equal to or less than a prescribed threshold value as the moment for stopping irradiation of the ion beam.

7. The charged particle beam device according to claim 6, further comprising a unit which changes the threshold value for an amount of blur.

8. The charged particle beam device according to claim 2, wherein the third control unit displays an amount of blur which is successively calculated as a time-series graph to a display apparatus.

9. A method for creating a sample using a charged particle beam device having an ion source, an ion beam optics system apparatus for irradiating an ion beam, a first control unit for controlling the irradiation of the ion beam, an electron source, an electron beam optics system apparatus for irradiating an electron beam, a second control unit for controlling the irradiation of the electron beam, a sample holding mechanism for holding a sample, a vacuum container, and a two-dimensional detector for acquiring a diffraction pattern which is created by electrons passing through the sample out of the electron beam, comprising the steps of:

   calculating an amount of blur of the diffraction pattern at a time of removal machining of a damaged layer of the sample with the ion beam; and
   controlling a moment for stopping irradiation of the ion beam to the sample based on the amount of blur.

10. A charged particle beam device comprising:

   an ion source;
   an ion beam optics system apparatus for irradiating an ion beam;
   a first control unit for controlling the irradiation of the ion beam;

an electron source;

an electron beam optics system apparatus for irradiating an electron beam;

a second control unit for controlling the irradiation of the electron beam;

a sample holding mechanism for holding a sample;

a vacuum container;

a two-dimensional detector for acquiring a diffraction pattern which is created by electrons passing through the sample out of the electron beam; and

a third control unit for calculating an amount of blur of the diffraction pattern at a time of removal machining of a damaged layer of the sample with the ion beam and for displaying the amount of blur to a display apparatus.

# FIG. 1

EP 2 660 846 A1

FIG. 2

FIG. 3

301
302
303

# FIG. 4

START

STEP 401 — INTRODUCE SAMPLE

STEP 402 — ADJUST MACHINING POSITION OF ION BEAM

STEP 403 — START REMOVAL MACHINING OF DAMAGED LAYER

STEP 404 — ACQUIRE DIFFRACTION PATTERN

STEP 405 — QUANTIZE AMOUNT OF BLUR AND DISPLAY ONTO SCREEN

STEP 406 — PRESENT AMOUNT OF BLUR OR CHANGE AMOUNT OF BLUR ≤ THRESHOLD?

NO

YES

STEP 407 — STOP IRRADIATION OF ION BEAM ONTO SAMPLE

END

FIG. 5

## FIG. 6

601

# FIG. 7A

# FIG. 7B

## FIG. 8A

## FIG. 8B

# FIG. 9

```
                    ┌─────────────┐
                    │    START    │
                    └──────┬──────┘
                           │
                           ▼
STEP 901     ┌──────────────────────────────────────┐
             │           INTRODUCE SAMPLE            │
             └──────────────────┬───────────────────┘
                                │
                                ▼
STEP 902     ┌──────────────────────────────────────┐◄────────────┐
             │   ADJUST MACHINING POSITION OF ION BEAM│            │
             └──────────────────┬───────────────────┘             │
                                │                                 │
                                ▼                                 │
STEP 903     ┌──────────────────────────────────────┐             │
             │   REMOVAL MACHINING OF DAMAGED LAYER  │             │
             └──────────────────┬───────────────────┘             │
                                │                                 │
                                ▼                                 │
STEP 904     ┌──────────────────────────────────────┐             │
             │          CONTROL SAMPLE STAGE         │             │
             └──────────────────┬───────────────────┘             │
                                │                                 │
                                ▼                                 │
STEP 905     ┌──────────────────────────────────────┐             │
             │       ACQUIRE DIFFRACTION PATTERN     │             │
             └──────────────────┬───────────────────┘             │
                                │                                 │
                                ▼                                 │
STEP 906     ┌──────────────────────────────────────┐             │
             │   QUANTIZE AMOUNT OF BLUR AND DISPLAY │             │
             │             ONTO SCREEN               │             │
             └──────────────────┬───────────────────┘             │
                                │                                 │
                                ▼                                 │
                         ╱───────────╲          NO                │
STEP 907               ╱   PRESENT     ╲──────────────┐           │
                      ╱  AMOUNT OF BLUR  ╲             │           │
                       ╲  ≤ THRESHOLD?  ╱              │           │
                        ╲─────┬───────╱               │           │
                              │ YES                   ▼           │
                              │               STEP 909            │
                              ▼           ┌──────────────────┐    │
STEP 908  ┌───────────────────────────┐  │CONTROL SAMPLE STAGE│──┘
          │STOP IRRADIATION OF ION BEAM│  └──────────────────┘
          │       ONTO SAMPLE          │
          └─────────────┬─────────────┘
                        │
                        ▼
                 ┌─────────────┐
                 │     END     │
                 └─────────────┘
```

**INTERNATIONAL SEARCH REPORT**

| International application No. |
|---|
| PCT/JP2011/078379 |

A. CLASSIFICATION OF SUBJECT MATTER
*H01J37/317*(2006.01)i, *H01J37/22*(2006.01)i, *H01J37/244*(2006.01)i,
*H01J37/28*(2006.01)i

According to International Patent Classification (IPC) or to both national classification and IPC

B. FIELDS SEARCHED

Minimum documentation searched (classification system followed by classification symbols)
H01J37/317, H01J37/22, H01J37/244, H01J37/28

Documentation searched other than minimum documentation to the extent that such documents are included in the fields searched
Jitsuyo Shinan Koho         1922–1996   Jitsuyo Shinan Toroku Koho   1996–2011
Kokai Jitsuyo Shinan Koho   1971–2011   Toroku Jitsuyo Shinan Koho   1994–2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2007-193977 A (Hitachi High-Technologies Corp.), 02 August 2007 (02.08.2007), paragraphs [0017], [0018], [0022] to [0025]; fig. 3, 5 (Family: none) | 1-10 |
| Y | JP 2000-123774 A (Hitachi, Ltd.), 28 April 2000 (28.04.2000), paragraphs [0002] to [0005] (Family: none) | 1-10 |
| Y | JP 2-109244 A (Sony Corp.), 20 April 1990 (20.04.1990), page 2, lower left column, lines 3 to 5 (Family: none) | 3,4 |

☒  Further documents are listed in the continuation of Box C.          ☐  See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 22 December, 2011 (22.12.11) | 10 January, 2012 (10.01.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

EP 2 660 846 A1

<table>
<tr><td colspan="2"><strong>INTERNATIONAL SEARCH REPORT</strong></td><td colspan="2">International application No.<br>PCT/JP2011/078379</td></tr>
<tr><td colspan="4">C (Continuation).   DOCUMENTS CONSIDERED TO BE RELEVANT</td></tr>
<tr><td>Category*</td><td colspan="2">Citation of document, with indication, where appropriate, of the relevant passages</td><td>Relevant to claim No.</td></tr>
<tr><td>A</td><td colspan="2">JP 9-133618 A  (Kawasaki Steel Corp.),<br>20 May 1997 (20.05.1997),<br>paragraph [0016]<br>(Family: none)</td><td>1-10</td></tr>
</table>

Form PCT/ISA/210 (continuation of second sheet) (July 2009)

23

**EP 2 660 846 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2007193977 A
- JP 2009129221 A
- JP 6060186 A